# EUROPÄISCHE PATENTANMELDUNG

(11) **EP 1 849 887 A1**
(43) Veröffentlichungstag der Anmeldung: **31.10.2007**
(21) Anmeldenummer: 07105115.5
(22) Anmeldetag: 28.03.2007
(51) Int. Cl.: C23C 14/34

(54) **Target für eine Sputterquelle**

(30) Priorität: 26.04.2006 EP 06405178
(71) Anmelder: Sulzer Metco AG, 5610 Wohlen (CH)
(72) Erfinder: Beele, Dr., Wolfram, 40883, Ratingen (DE); Eschendorff, Gerald, 5913, TE Venlo (NL)
(74) Vertreter: Sulzer Management AG

(57) **Zusammenfassung**

Ein Target für eine Sputterquelle ist in eine Vielzahl von austauschbaren Targetsegmenten (9) unterteilbar. Jedes Targetsegment (9) enthält Beschichtungsmaterial, wobei jedes Targetsegment (9) an zumindest zwei benachbarte Targetsegmente (9', 9") grenzt, wobei jedes Targetsegment mittels maximal einem Befestigungsmittel (7,8,10) mit einem Grundkörper (2,13,15) verbindbar ist.

## Beschreibung

Die Erfindung betrifft ein Target sowie eine zugehörigeTargethaltevorrichtung, welches in einem Beschichtungsverfahren Einsatz findet. Das Beschichtungsverfahren umfasst insbesondere ein Gasflusssputterverfahren zur Aufbringung von hochtemperaturbeständigen Haftschichten auf ein Substrat, wie insbesondere auf eine Turbinenschaufel. Das Target enthält das Beschichtungsmaterial, welches insbesondere durch lonen eines ionisierten Inertgasplasmas aus dem Target abstäubbar sind. Das Target ist auf einer Targethaltevorrichtung im Gehäuse einer Beschichtungsquelle untergebracht. Das vom Target abgestäubte Beschichtungsmaterial gelangt mittels des ionisierten Inertgasplasmastroms zu dem zu beschichtenden Substrat. Die Beschichtungsquelle befindet sich einer geschlossenen Vakuumkammer, welche kontinuierlich abgepumpt wird. Das ionisierte Inertgas und die abgeschiedenen Beschichtungspartikel des Targets gelangen innerhalb der Kammer zum Substrat bzw. werden durch die Vakuumpumpe abgesaugt. Ein Target wird auf einer Targethaltevorrichtung aufgelötet oder direkt mit der Targethaltevorrichtung verschraubt. Eine mögliche Lösung besteht darin, ein Sackloch in die Targethaltevorrichtung zu bohren, in welches das Target geschraubt wird. Das Target ist im Betrieb einem hohen Wärmeeintrag ausgesetzt, weil einerseits ein Stromfluss zur Bereitstellung der elektrischen Ladungen zur Erzeugung der Kathodenwirkung vorgesehen ist und andererseits die Generierung und Aufrechterhaltung des Plasmazustands des Gases auf bestimmten Temperatur- und Druckbereiche begrenzt ist. Diese Wärme muss über den Targethalter abgeführt werden. Sowohl bei einer Lötverbindung, als auch bei einer Einschraublösung können insbesondere in Temperaturbereichen oberhalb 400°C Überhitzungen im Target auftreten, da die Wärme nicht über die Kontaktflächen der Lötverbindung oder der Schraubverbindung abgeführt werden kann. Derartige Überhitzungen haben zur Folge, dass hohe Eigenspannungen im Target entstehen, die zu einer Rissbildung und demzufolge zum vorzeitigen Ausfall des Targets führen können.

Aus dem Stand der Technik ist bekannt, ein oder mehrere Sacklöcher in einen Targetgrundkörper zu bohren. Der Targetgrundkörper ist als Scheibe aus einem Beschichtungsmaterial gebildet, in welchen zylindrische Targets in Sacklöcher mittels Schrumpfverbindung eingebracht sind.

Ein derartiges Sackloch grenzt ja immer nur an den Grundkörper also ein einziges Teil. Ein Problem, welches bei Verwendung dieses Standes der Technik auftritt, besteht darin, dass durch unterschiedliche Wärmespannungen nicht gewährleistet werden kann, dass der Verbund zwischen Targetgrundkörper und zylindrischen Targets aufrechterhalten werden kann. Ein weiteres Problem dieser Ausführungsform ist die Notwendigkeit, Bohrungen im Targetgrundkörper vornehmen zu müssen, was einen nicht unbeträchtlichen Materialverlust zur Folge hat. Bei Beschichtungsmaterialien, die insbesondere Seltene Erden, Platin, Titan oder ähnliche Werkstoffe enthalten, sind die Kosten des Materials nicht vernachlässigbar.

Ein weiterer Nachteil ist darin begründet, dass die Grundkörper mit den zylindrischen Targets nur als Ganzes demontierbar sind.

Ein weiterer Nachteil liegt darin, dass mit der Kombination von Grundkörper und zylindrischen Targets die Zusammensetzung der Beschichtung im wesentlichen festgelegt ist und eine Änderung derselben nur durch Ersatz des Grundkörpers und/oder der zylindrischen Targets möglich ist.

Aus der DE 44 26 751 A1 ist ein Sputtertarget bekannt, welches in einem Kathodenzerstäubungsprozess zum Einsatz kommt. Ab einer gewissen Flächengrösse des Sputtertargets kommt es zu Längenänderungen durch die Ausdehnung des Sputtertargets bei Erwärumung desselben, wodurch es zu Wärmespannungen im Sputtertarget kommt, welches an einer Targetrückplatte befestigt ist. Diese Wärmespannungen können insbesondere bei Sputtertargets grosser Ausdehnung zu einer Beschädigung des Sputtertargets und/oder der Targetrückplatte führen. Aus diesem Grund wird in der DE 44 26 751 A1 vorgeschlagen, das Sputtertarget aus einzelnen Segmentkörpern zusammenzusetzen, die im nicht erwärmten Zustand in einem Abstand zueinander stehen und sich im erwärmten Zustand gerade berühren. Ein Nachteil dieser vorbekannten Lösung ist darin begründet, dass die Abstände der Segmentkörper für jede Materialkombination neu bestimmt werden müssen. Ein weiterer Nachteil dieser Lösung ist die Notwendigkeit einer Vielzahl von Befestigungspunkten pro Targetsegment. In diesem Fall wirken sich die Wärmespannungen auch zwischen den Befestigungspunkten derart aus, dass im Bereich der Befestigungspunkte Risse oder Brüche auftreten, insbesondere, wenn für das Targetsegment sprödes Material verwendet wird oder gesinterte oder gepresste Pulver, die keine ausreichende Druck- und/oder Zugfestigkeit aufweisen. Ein weiterer Nachteil der vorbekannten Lösung ist in der geringen Wärmeaustauschfläche zwischen Targetsegment und der an ein Kühlsystem angeschlossenen Targetrückplatte begründet, da die Wärme im wesentlichen über die Schraubverbindung abgeführt werden muss. Nach einem Ausführungsbeispiel wird zudem das Sputtertarget zusammen mit der Targetrückplatte auf dem Katodenkörper "schwimmend", has heisst parallel zur Sputtertargetfläche verschiebbar gelagert. Zwar werden durch diese Massnahme die durch die Befestigung entstehenden Wärmespannungen vermindert, aber auch die Wärmeabfuhr in das Kühlsystem reduziert.

Ein anderes Problem in Zusammenhang mit der Verwendung von Targetsegmenten wird in der DE 197 38 815 A1 beschrieben. Die Verwendung von Targetsegmenten erfordert spezielle Montagelösungen, insbesondere wenn gewährleistet werden soll, dass ein Targetsegment flächig auf einer Kathodenplatte aufliegen soll, um den vorstehend beschriebenen mangelhaften Wärmeübergang zu verbessern. Allerdings erfordert auch die in DE 197 38 815 A1 vorgestellte Montagelösung den Einsatz von Justierbolzen zur Positionierung der Targetsegmente. Daraus folgt aber, dass zumindest eine zweite Befestigungsmöglichkeit pro Targetsegment vorhanden sein muss, da der Justierbolzen nur die Aufgabe der Zentrierung und Positionierung des Targetsegments übernimmt. Somit treten bezüglich der in das Targetsegment eingeleiteten Wärmespannungen genau dieselben Probleme auf, die schon in Zusammenhang mit der in der DE 44 26 751 A1 vorgestellten Targetsegmentanordnung dargestellt worden sind.

Des weiteren ist aus der DE10227048 bekannt, eine Hohlkathode aus einer Mehrzahl von Targets herzustellen, wobei mindestens 4, die Seitenflächen eines Prismas bildende Targets vorgesehen sind. Vorteil dieser Anordnung im Vergleich mit einer zylindrischen Hohlkathode ist die leichtere Herstellbarkeit von Targetplatten. Diese Targetplatten werden mittels einer zentralen Schraube an einem Kühlkörper befestigt, sodass die Targetplatte mit seiner Rückseite den Kühlkörper zwar ganzflächig berührt, jedoch nur punktuell mittig befestigt ist. Ziel ist es, die Wärmeaustauschfläche optimal auszunutzen, allerdings ergeben sich Wärmeverluste an der Schraube. Diese Wärmeverluste können jedoch gerade bei Verwendung kleiner Targets eine Verschlechterung des Wärmeübergangs bewirken. Auf die Problematik des begrenzten Stromflusses wird auch in dieser Veröffentlichung kein Bezug genommen. Der Strom muss über die Schraube zum Target zugeführt werden. Die Leistungsdichte wird daher durch den Querschnitt der Schraube oder die Auflageflächen im Gewinde unter der Annahme einer unvollständigen Verschraubung begrenzt. Tests mit einer vergleichbaren Anordnung unter Verwendung von MCrAlY oder NiAl Targets haben gezeigt, dass bei einer Temperatur von ungefähr 900°C und einer Einkoppelleistung von maximal 5 kW (bis zu 15 W/cm²) bereits gebrochene und/oder verbogene Targets beobachtet wurden. In diesem Fall wurden die Targets mit einer Klemmverbindung befestigt. Wurden Targets direkt mit dem Kühlkörper verschraubt, die in der DE 102 27 048 A1 beschrieben, schmolzen Targets bei einer Einkoppelleistung von maximal 10 kW (bis zu 21 W/cm²). Die Targets wurden zu heiss und somit beschädigt.

Aufgabe der Erfindung ist es daher, ein Target vorzusehen, welches Targetsegmente umfasst, die mittels einer Targethaltevorrichtung derart an das Kühlsystem angebunden werden, dass keine Wärmespannungen in das Targetsegment eingeleitet werden, sowie für ausreichende Wärmeabfuhr gesorgt wird. Eine weitere Aufgabe der Erfindung ist es, die Einkoppelleistung sowie die Leistungsdichte zu erhöhen, um die Dauer eines Beschichtungsvorgangs zu verringern.

Die Lösung der Aufgabe erfolgt durch den kennzeichnenden Teil von Anspruch 1. Ein Target für eine Sputterquelle ist in eine Vielzahl von austauschbaren Targetsegmenten unterteilbar, wobei das Targetsegment Beschichtungsmaterial enthält, wobei jedes Targetsegment an zumindest zwei benachbarte Targetsegmente grenzt. Jedes Targetsegment ist mittels maximal einem Befestigungsmittel mit einem Grundkörper verbindbar.

Ein Targetsegment steht für ein Element aus Beschichtungsmaterial, welches sich in einer Beschichtungsquelle befindet, die zur Verwendung in einem Beschichtungsverfahren, wie insbesondere einem Gasflusssputterverfahren verwendet wird. Für das Beschichtungsverfahren kommt eine Beschichtungsvorrichtung zum Einsatz, welche die Beschichtungsquelle, sowie das zu beschichtende Substrat umfasst. Die Beschichtungsquelle umfasst die Gesamtheit der Targetsegmente, die Targethaltevorrichtung für jedes Targetsegment, eine Verteilungsvorrichtung für ein Gas, welches ein Inertgas, insbesondere Argon oder ein Reaktivgas, insbesondere in sauerstoffhältiges Gas umfasst. Weiters umfasst die Beschichtungsquelle einen Kühlkörper mit Kühlmittelanschluss, insbesondere Wasseranschluss sowie ein Gehäuse zur Aufnahme aller oben genannten Komponenten sowie Mittel zur Isolierung der gesamten Beschichtungsquelle. Diese Mittel zur Isolierung bewirken die vollständige elektrische und weitgehend vollständige thermische Isolierung der Beschichtungsquelle vom Sputterraum. Mit Sputterraum wird der Bereich der Beschichtungsvorrichtung bezeichnet, der zumeist als Vakuumkammer ausgebildet ist, in welcher die Beschichtung abläuft, das heisst, in diesem Bereich der Vakuumkammer befindet sich das zu beschichtende Bauteil oder die zu beschichtenden Bauteile. Das Beschichtungsmaterial ist auf dem Targetsegment angeordnet. Die Beschichtungsquelle kommt insbesondere in einem Gasflusssputterverfahren zum Einsatz, für welches in der Folge die Abkürzungen GF-PVD (gas flow physical vapor deposition) oder auch HS-PVD (high speed physical vapor deposition) verwendet werden soll. Für das Gasflusssputterverfahren, werden zumeist zwei gegenüberliegende Targetsegmente verwendet. Diese Targetsegmente können je nach Grösse und gewünschter Sputterrate als einzelnes Element ausgeführt sein oder aus einer Vielzahl von Einzelsegmenten, eben den vorgenannten Targetsegmenten, bestehen. Somit bedeutet der Ausdruck Targetsegment in dieser Anmeldung anstelle von Target, dass zumindest ein Targetsegment pro Targethaltevorrichtung verwendet wird. Die Segmentierung des Targets erlaubt es, höhere Beschichtungsraten und Leistungseinkopplungen zu erzielen. Sollten höhere Beschichtungsraten und Leistungseinkopplungen von sekundärer Bedeutung sein, kann mit der vorliegenden Anordnung der Beschichtungsquelle im Sputterverfahren auch ohne Segmentierung gearbeitet werden. Durch die Verwendung von Targetsegmenten ist es möglich, eine höhere elektrische Leistung in jedes Targetsegment einzukoppeln, wodurch das Abstäuben von Schichtmaterial vom Targetsegment beschleunigt wird, sodass eine höhere Zerstäubungsrate erzielbar ist. Die Verwendung von Targetsegmenten bietet auch Vorteile, die die Haltbarkeit und mechanischen Eigenschaften der Targetsegmente betreffen. Durch die geringen Spannungen in jedem Targetsegment kommt es nicht zu Rissen oder Brüchen im Beschichtungsmaterial. Des weiteren erhöht sich die Temperaturbeständigkeit der Anordnung der Tagetsegmente, weil die Wärme besser abgeführt werden kann, wodurch es auf keinem der Targetsegmente zum Schmelzen des Materials kommt. Jedes der Targetsegmente hat insbesondere seinen eigenen Stromanschluss sowie einen eigenen Anschluss an den Kühlkörper. Die Hauptfunktion des Kühlkörpers besteht darin, die auf den Targetsegmenten während des Beschichtungsverfahrens entstehende Wärme abzuführen. Der Leistungseintrag, welcher, verursacht durch Ströme insbesondere bis zu 150 A je Target, Leistungsdichten insbesondere bis zu 220 W/cm² auf der Targetoberfläche hervorruft, sowie die Stossenergie der auf das Targetsegment auftreffenden Gasatome erzeugen die abzuführende Wärmeenergie. Als Gas kann einerseits in einem Beschichtungsverfahren zur Beschichtung mit einem metallischen Beschichtungsmaterial ein Inertgas zum Einsatz kommen, wobei sich insbesondere Argon als geeignet erwiesen hat. Die Stossenergie dieser Argonatome führt ebenfalls zu einem Wärmeeintrag in das Targetsegment. Durch den Stoss werden Atome des Beschichtungsmaterials aus ihrem Verbund an der Targetsegmentoberfläche herausgelöst. Hierbei werden hohe Temperaturen erreicht. Um den Prozess besser zu kontrollieren, kann zusätzlich mittels einer Strahlungsheizvorrichtung geheizt werden, um Beschichtungstemperaturen je nach Substrat und Schicht insbesondere bis zu ca. 1150 Grad Celsius in der Beschichtungskammer zu erzielen. Die Beschichtungsvorrichtung kann auch für reaktives Gasflusssputterverfahren zum Einsatz kommen. Anstatt oder zusätzlich zum Inertgas wird Reaktivgas, insbesondere sauerstoffhältiges Gas zugeführt, wodurch es zu Reaktionen des Beschichtungsmaterials mit den Gasmolekülen am Targetsegment oder in der Gasphase nach Ablösung vom Targetsegment kommt, sodass es durch die meist exotherm ablaufenen chemischen Reaktionen, insbesondere Oxidationsreaktionen zur Temperaturerhöhung kommt. Um eine Überhitzung des Targetsegments bei einer Beschichtungsdauer von einigen Stunden zu vermeiden, wird jedes Targetsgment gekühlt, wobei insbesondere Wasserkühlung zum Einsatz kommt. Für die Einkopplung höherer Ströme, die höheren Wärmeübergang am Targetsegment zur Folge haben, ist es vorteilhaft, eine Vielzahl von einzelnen Targetsegmenten in der Beschichtungsvorrichtung zu verwenden. Um die oben genannten Spannungen im Targetsegment zu vermeiden oder soweit zu verringern, dass sie unterhalb der Rissbildungsspannung des Targetsegmentmaterials liegen, wird die im folgenden beschriebene erfindungsgemässe Targethaltevorrichtung verwendet.

Die Beschichtungsquelle umfasst somit das oder die Targetsegmente, den Stromanschluss für jedes der Targetsegmente, einen Anschluss jedes der Targetsegmente an das Kühlsystem zur Zu- und Ableitung eines Kühlmittels. Die Zufuhr des Inertgases und/oder Reaktivgases erfolgt über Gasanschlüsse, sowie Gasverteiler, welche derart angeordnet sind, dass eine gleichmässige Verteilung der Gasmenge mit einer gleichen mittleren Auftreffgeschwindigkeit auf alle Targetsegmente erfolgt. Apparativ ist jedes Targetsegment in einer Targethaltevorrichtung aufgenommen. Die Targethaltevorrichtung umfasst den oder die Kühlkörper, sowie eine Aussenwand, sowie Verbindungsmittel zur Anbindung des Targetsegments an den Kühlkörper sowie der Aussenwand der Beschichtungsquelle.

Ein weiterer Vorteil besteht in der Möglichkeit, die Targetsegmente nach Abschluss des Beschichtungsverfahren einzeln zu demontieren, wenn das Beschichtungsmaterial verbraucht ist, um sie im Rahmen eines Wiederaufbereitungsschrittes wieder mit Beschichtungsmaterial zu versehen.

Bei Verwendung kleiner Segmente sind die Eigenspannungen im Targetsegment begrenzt, sodass auch spröde, sowie schlecht verbindbare Beschichtungsmaterialien und/oder Beschichtungsmaterialkombinationen einsetzbar sind. Bei hoher Temperaturbelastung können zudem Targetsegmente mit kleineren Abmessungen gewählt werden, sodass der Anteil der über die Befestigungsvorrichtung abführbaren Wärme zunimmt. Diese Verbesserung des Wärmeübergangs ist darin begründet, dass die Wärmeaustauschfläche gegenüber der Wärmeaustauschfläche nach dem Stand der Technik vergrössert ist, weil die Befestigungsvorrichtung relativ zum Targetsegment über eine grössere gemeinsame Oberfläche verfügt. Zudem kann der Wärmeübergang durch die Verwendung von Kontaktlamellen derart verbessert werden, dass der limitierende Faktor für den Wärmeübergang nicht mehr die Abführung der Wärme vom Targetsegment zum Kühlkörper ist, sondern der Wärmeübergang viel mehr durch die Leistung des Kühlkörpers begrenzt wird.

Ein weiterer Vorteil besteht in der Möglichkeit, die Targets wieder aufzuarbeiten (mittels HIP, Spritzverfahren) wobei die Nut / Feder Verbindung am Target erhalten bleibt.

Bei Verwendung kleiner Segmente sind die Eigenspannungen im Target begrenzt, sodass höhere Leistungseinkopplungen möglich werden. Durch die Oberflächenvergrösserung sinkt auch die Wärmebelastung am Target.

Die Verwendung einer einzigen Befestigungsvorrichtung pro Target trägt zur Reduktion der Eigenspannungen bei, sodass die Verwendung spröder und harter Beschichtungsmaterialien möglich ist.

Weitere vorteilhafte Ausgestaltungen der Erfindung sind Gegenstand der Unteransprüche.

Nach einem vorteilhaften Ausführungsbeispiel für das Target für eine Sputterquelle umfasst das Befestigungsmittel elektrisch und/oder thermisch leitfähige Mittel, sodass im Betriebszustand eine gleichmässige Stromstärke über die Oberfläche des Targetsegments verteilbar sowie die am Targetsegment entstehende Wärme gleichmässig in den Grundkörper abführbar ist.

Nach einem vorteilhaften Ausführungsbeispiel für das Target für eine Sputterquelle umfasst das Befestigungsmittel eine Steckverbindung.

Nach einem vorteilhaften Ausführungsbeispiel für das Target für eine Sputterquelle, ist eine Steckverbindung für eine Vielzahl von Targetsegmenten vorgesehen.

Nach einem vorteilhaften Ausführungsbeispiel für das Target für eine Sputterquelle umfasst der Grundkörper einen Kühlkörper, an welchen jedes Targetsegment elektrisch und thermisch ankoppelbar ist.

Nach einem vorteilhaften Ausführungsbeispiel für das Target für eine Sputterquelle besteht jedes Targetsegment vollständig aus Beschichtungsmaterial. Durch die Ausgleichsmöglichkeit der Wärmespannungen durch das Vorsehen von federnden Kontaktelementen wird das Targetsegment frei von Wärmespannungen gehalten.

Nach einem vorteilhaften Ausführungsbeispiel für das Target für eine Sputterquelle umfasst ein Targetsegment zumindest ein erstes Schichtmaterial oder eine erste Kombination von Schichtmaterialien, die sich von dem Schichtmaterial oder der Kombination von Schichtmaterialien eines zweiten Targetsegments unterscheiden.

Das Target nach einem der vorhergehenden Ausführungsbeispiele findet insbesondere in einer Beschichtungsquelle für ein Gasflusssputterverfahren Verwendung.

Ein Verfahren zur Beschichtung eines Bauteils umfasst eine Sputterquelle, ein Target sowie ein Gas zum Transport von abgestäubtem Beschichtungsmaterial zu dem Bauteil umfassend die Schritte: Kontakt eines Gases mit der Targetoberfläche, Herauslösen von Teilchen aus der Targetoberfläche, Mitnahme der herausgelösten Teilchen mit dem Gasstrom, Beschichtung des Bauteils mit Teilchen aus dem Gasstrom, wobei der Gasstrom die Teilchen des zu beschichtenden Bauteils aus jedem Targetsegment anteilig herauslöst.

Die Teilchen umfassen geladene Teilchen, wie insbesondere lonen und/oder neutrale Teilchen, wie insbesondere Atome.

Für die Durchführung des Sputterverfahrens werden die Sputterquelle, umfassend ein Target, welches die vorgehend beschriebenen Targetsegmente enthält, stosserzeugende Mittel, also insbesondere Gasatome und/oder Ionen sowie Bewegungsmittel, insbesondere ein bewegter Gasstrom benötigt. Die stosserzeugenden Mittel kontaktieren das Target, um durch ihr stossartiges Auftreffen auf der Targetoberfläche Teilchen aus der Oberfläche des Targets durch die Stossenergie des auftreffenden stosserzeugenden Mittels herauzulösen. Ein Bewegungsmittel dient zum Transport der abgestäubten Teilchen von der Sputterquelle zu einem zu beschichtenden Bauteil.

Insbesondere werden gemäss des vorhin beschriebenen Verfahrens durch den Gasstrom Teilchen derart aus den Targetsegmenten herausgelöst, dass der Anteil der verschiedenen Schichtmaterialien oder Schichtmaterialkombinationen auf dem Bauteil dem Anteil der Targetsegmente mit entsprechenden Schichtmaterialien oder Schichtmaterialkombinationen auf dem Target entspricht, sodass das Bauteil mit einem ersten Schichtmaterial oder einer ersten Schichtmaterialkombination eines ersten Targetsegments und mit einem zweiten Schichtmaterial oder einer zweiten Schichtmaterialkombination eines zweiten Targetsegments anteilig beschichtet wird.

Insbesondere wird der Anteil der vom Gasstrom abgestäubten verschiedenen Schichtmaterialien oder Schichtmaterialkombinationen nach einem vorteilhaften Ausführungsbeispiel durch eine relativ zum Target bewegliche Gasverteilungseinheit verändert.

Das in dem vorhin beschriebenen Verfahren zur Anwendung kommende Gas umfasst insbesondere ein Inertgas, insbesondere Argon und/oder ist als quasineutrales Plasma ausgebildet.
Fig. 1 zeigt eine Zusammenstellung einer Targethaltevorrichtung nach einem ersten Ausführungsbeispiel
Fig. 2 zeigt einen Schnitt durch die Targethaltevorrichtung nach Fig. 1
Fig. 3 zeigt eine Zusammenstellung einer Targethaltevorrichtung nach einem zweiten Ausführungsbeispiel
Fig. 4 zeigt einen Schnitt durch die Targethaltevorrichtung nach Fig. 3
Fig. 5 zeigt eine Zusammenstellung einer Targethaltevorrichtung nach einem dritten Ausführungsbeispiel
Fig. 6 zeigt einen Schnitt durch die Targethaltevorrichtung nach Fig. 5
Fig. 7 zeigt eine Zusammenstellung einer Targethaltevorrichtung nach einem vierten Ausführungsbeispiel
Fig. 8 zeigt einen Schnitt durch die Targethaltevorrichtung nach Fig. 7

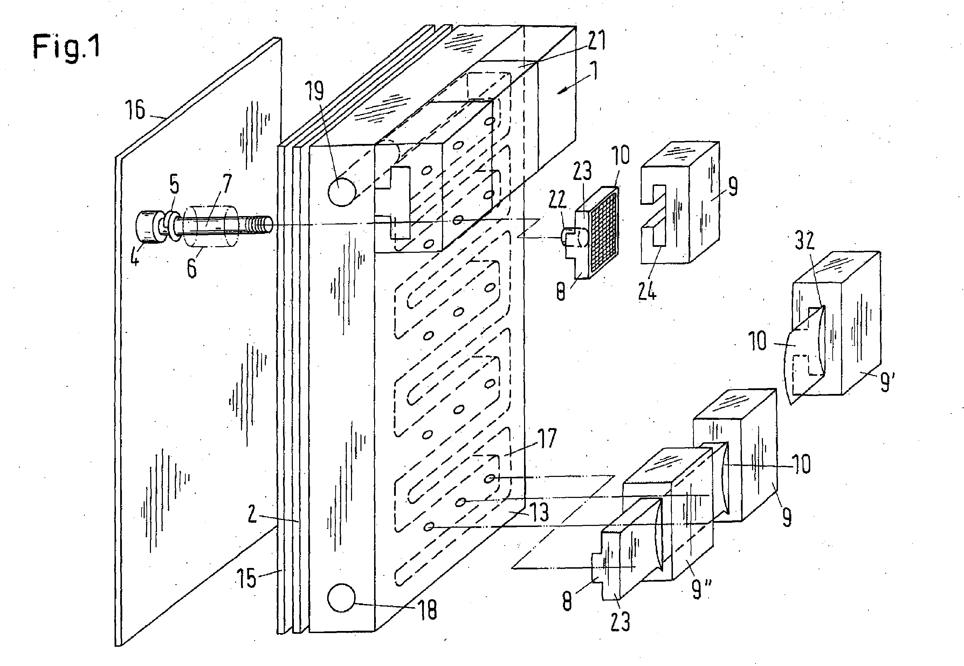

Fig. 1 zeigt die Anordnung eines Targetsegments 9, welches mit einer Targethaltevorrichtung 1 in der Beschichtungsquelle befestigt wird. Jedes Targetsegment 9 wird mittels einer T-Mutter 8 mit der Kühlkörperaussenwand 2 verschraubt. Die T-Mutter besteht aus einem Zylinder 22 und einem Fortsatz 23, welcher einen T-förmigen Querschnitt aufweist. Der Zylinder 22 wird von einer Bohrung im Kühlkörper 13 aufgenommen. Der T-förmige Fortsatz 23 ragt über die Oberfläche der Innenseite des Kühlkörpers 21 hinaus. An der T-Mutter ist eine Kontaktlamelle 10 aus niedrig legiertem Kupfer oder Nickel insbesondere aus CuBe, CuCoBe oder NiBe befestigt und/oder eine galvanische Beschichtung angebracht. Auf die T-Mutter 8 wird zumindest ein Targetsegment 9 aufgesteckt, wobei T-Mutter und Targetsegment einen Zwischenraum aufweisen, in welchem die Kontaktlamelle 10 angeordnet ist. In Fig. 1 wird das Targetsegment 9 auf den T-förmigen Fortsatz 23 gesteckt. Im Targetsegment ist eine Nut 24 angebracht, die eine Erweiterung in der Form eines T aufweist, die passend zu der Form des Fortsatzes 23 ausgestaltet ist. Der T-förmige Fortsatz 23, welcher in einer zughörigen Nut 24 des Targetsegments 9 eingreift, kann zur Aufnahme zumindest eines Targetsegments 9 verwendet werden. In Fig. 1 ist auch eine mögliche Variante dargestellt, in welcher ein T-förmiger Fortsatz 23 zur Aufnahme mehrerer Targetsegmente 9 dient. Ein Targetsegment wird in gleicher Weise wie die schon aufgesteckten Targetsegmente auf seine Position auf dem T-förmigen Fortsatz 23 verschoben, wobei die Anzahl der Targetsegmente pro T-Mutter von der Segmentbreite abhängig ist, die wiederum mit der Quellengrösse in direkter Beziehung steht. Die Targetsegmente stecken allesamt auf den T-Muttern und/oder zugehörigen Kontaktlamellen und/oder zugehörigen galvanischen Beschichtungen. Jedes der Targetsegmente 9 wird in einer zur Form des Fortsatzes 23 korrespondierenden Gegenform aufgenommen, wobei in Fig. 1 eine Nut in der Form eines T dargestellt ist, wobei aber auch andere formschlüssige Verbindungen zum Einsatz kommen können, mittels welchen die T-Muttern und/oder Kontaktlamellen zumindest teilweise umgriffen werden. Insbesondere kann im Targetsegment 9 eine Schwalbenschwanznut vorgesehen sein. Eine Kontaktlamelle 10 ist in der Nut des Targetsegments 9 angeordnet. Die Kontaktlamelle und/oder die galvanische Beschichtung leitet durch ihre guten Wärmeleiteigenschaften die Wärme vom Targetsegment in Richtung des Kühlsystems. Zur Verbesserung des Wärmeübergangs von Targetsegment 9 zu den Kontaktlamellen 10 kann auch auf den Kontaktlamellen eine galvanische Beschichtung vorgesehen sein. Die galvanische Beschichtung befindet sich insbesondere auf der dem oder den Targetsegmenten 9 zugewandten Oberfläche der Kontaktamellen 10, wenn die Kontaktlamelle in der T-Mutter gehalten wird. Wenn die Kontaktlamelle 10 in dem Targetsegment 9 aufgenommen ist, befindet sich die galvanische Beschichtung auf der Seite der Kontaktlamelle, die der T-Mutter zugewendet ist. Auf das Targetsegment 9 prallen im Betrieb, also während des Beschichtungsverfahrens, die Atome und/oder lonen eines Inertgases auf. Sie schlagen aus dem Targetsegmentmaterial Atome heraus. Durch die Stösse der auf das Targetsegmentmaterial auftreffenden lonen kommt es zum Eintrag von Wärmeenergie in das Targetsegment 9, die über die Kontaktlamellen 10, die T-Mutter 8, sowie die Befestigungsschraube 7 zum Kühlkörper 13 abgeführt wird.

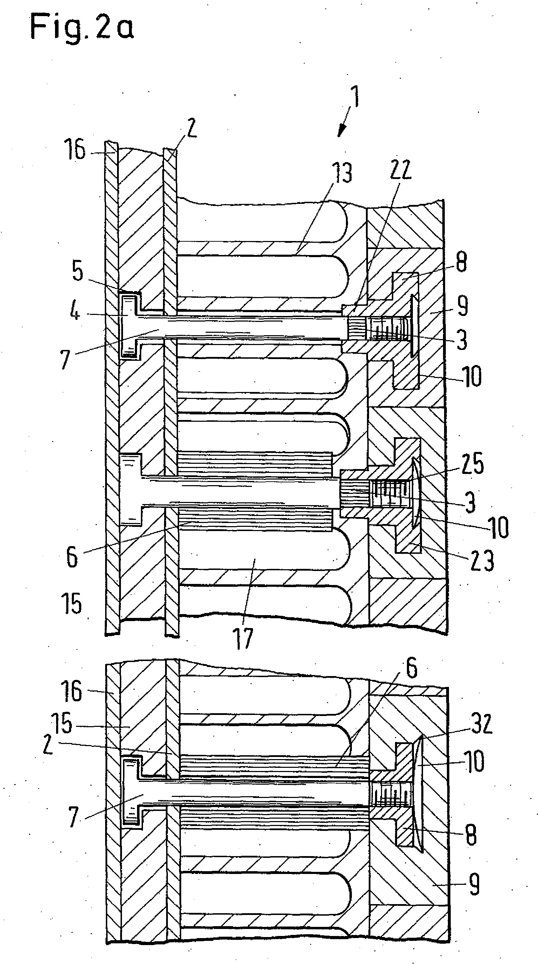

In Fig. 2a ist die Targethaltevorrichtung 1 aus Fig. 1 im Schnitt dargestellt. In Fig. 2a ist die Befestigungsschraube 7 nur im oberen Teil der Figur dargestellt, im unteren Teil ist die Befestigungsschraube 7 weggelassen, um die Übersichtlichkeit zu erhöhen. Die zuunterst gezeigte Befestigungsschraube in Fig. 2a zeigt eine vereinfachte Variante, wenn eine Positionierung der T-Mutter im Kühlkörper durch den in das Innere des Kühlkörpers 13 hineinragenden Zylinder 22 der T-Mutter 8 nicht erforderlich ist. Diese Variante kann zum Einsatz kommen, wenn das Target nur aus einer geringen Anzahl von Targetsegmenten besteht, oder wenn die Position des Targetsegments bereits durch benachbarte Targetsegmente festgelegt ist. Aneinandergrenzende Targetsegmente können sich berühren, wenn die Temperaturbelastung zu gering ist, um eine merkliche Wärmedehnung zu verursachen oder die Targetsegmente aus einem Beschichtungsmaterial oder einer Kombination von Beschichtungsmaterialien aufgebaut sind, deren Wärmedehnung auch bei hohen Temperaturen vernachlässigbar ist, das heisst unter 0,5 mm, insbesondere unter 0,1 mm, bevorzugt unter 0,05 mm liegt. In der zuunterst in Fig. 2a dargestellten Variante ist des weiteren gezeigt, dass das Targetsegment eine Ausnehmung 32 in der Nut 24 aufweist, um eine Kontaktlamelle 10 aufzunehmen.

Die Grösse eines Targetsegments ist derart einstellbar, dass bei gewünschtem Leistungseintrag das Targetsegment so kleine Längs- , Breiten, sowie Tiefenabmessungen aufweist, dass der maximal mögliche Wärmeeintrag über die Targetsegmentoberfläche, die dem Gasstrom ausgesetzt ist, begrenzt bleibt. Die Befestigungsvorrichtung wird derart dimensioniert, dass die gesamte Wärme über die T-Mutter 8 oder die Gabelsteckvorrichtung 12, und/oder über die Befestigungsschraube 7 mit der zugehörigen Kontaktlamelle 3 abgeführt werden kann, sodass die Kühlleistung des als Kühlkörper 13 ausgeführten Kühlsystems zum limitierenden Faktor für die Wärmeübertragung wird.

Durch jede der dargestellten Kontaktlamellen 10 wird nicht nur eine Verbesserung des Wärmeübergangs durch Vergrösserung der Wärmeübertragungsfläche, sondern auch ein Ausgleich der Wärmespannungen des temperaturbelasteten Targetsegments erreicht. Die Kontaktlamelle 10 wirkt als Federmechanismus, dessen Funktion darin besteht, die Wärmeausdehnungseffekte des Beschichtungsmaterials abzufedern, wodurch die aus dem Stand der Technik bekannten Spaltabstände und andere Lösungen, welche Passstifte umfassen, nicht mehr benötigt werden. Der Einsatz der Kontaktlamellen 10 hat auch den Vorteil, dass die Anbindung an die Wärmeabfuhr durch den Kühlkörper 13 und die Anbindung an die Stromübertragung während der Dauer des gesamten Beschichtungsverfahrens in gleichmässiger Weise erfolgt. Mittels der Kontaktlamellen kann gewährleistet werden, dass Stromübertragung, sowie Wärmeabfuhr durch Wärmeleitung zeitlich weitgehend konstant verlaufen, wodurch ein unter gleichmässigen Randbedingungen für Stromübertragung, sowie Wärmeabfuhr verlaufender Sputterprozess ermöglicht wird. Als Kontaktlamelle kann eine biegbare Folie zum Einsatz kommen.

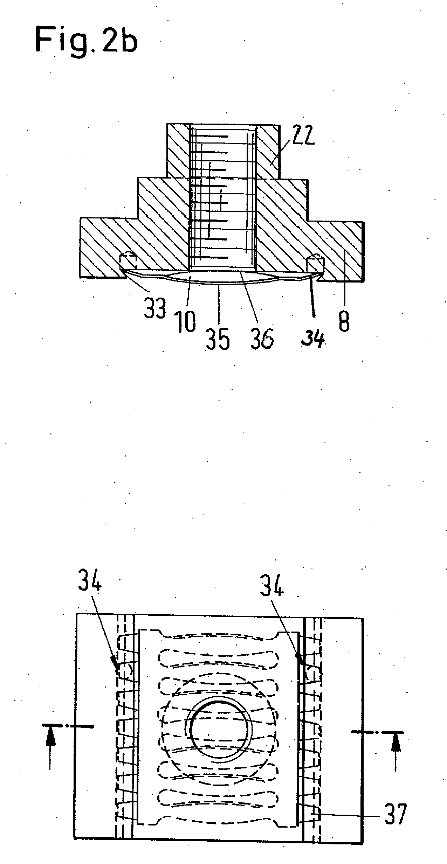

Vorteilhafterweise kann auch eine standardmässig erhältliche Kontaktlamelle zum Einsatz kommen, wie in Fig. 2b dargestellt wird. Die Kontaktlamelle 10 wird in eine Nut 33 der T-Mutter 8 eingeschoben und kann unter Vorspannung in dieser Nut aufgenommen sein und/oder über ein Arretierelement 34 gegen axiale Verschiebung gesichert sein. Zur Vergrösserung der Vorspannung kann eine Kontaktlamelle erste Bereiche 35 umfassen, welche sich im eingebauten Zustand auf der von der Kontaktlamelle überspannten Fläche der T-Mutter abstützen, sowie zweite Bereiche 36 umfassen, die im eingebauten Zustand einen Kontakt mit dem Targetsegment aufrecht erhalten. Zudem erfolgt die Wärmeabfuhr durch Wärmeleitung von dem Targetsegment über die zweiten Bereichen 36 und/oder über die ersten Bereiche 35 sowie über die in der Nut aufgenommenen Stege 37 zu der T-Mutter. Die Wärmeleitung über die Kontaktlamelle und die T-Mutter erfolgt so schnell, dass die abzuführende Wärmemänge durch die Kühlleistung des Kühlkörpers beschränkt ist. Somit ergibt sich durch die Verwendung der Kontaktlamelle nicht nur ein gleichmässiger Kontakt zum Eintrag von elektrischem Strom in das Targetsegment, sondern auch ein verbesserter Wärmeübergang. Da die Kontaktlamelle als Federmechanismus wirkt, kann jede beliebige Vorspannung je nach Ausführung der Kontaktlamelle eingestellt werden. Einerseits besteht die Möglichkeit, die Wandstärke der Kontaktlamellen zu variieren, andererseits kann der Anteil der ersten und zweiten Bereiche (35,36) variiert werden, um eine genau definierte und reproduzierbare Vorspannung zu erreichen. Die Kontaktlamelle wird dabei vorzugsweise im elastischen Bereich verformt, sodass sie für mehrmalige Montage- und Demontagezyklen einsetzbar ist.

Im Innern des insbesondere als Zylinder 22 ausgebildeten Teils der T-Mutter 8 befindet sich ein Innengewinde 25, wie in Fig. 2a dargestellt ist. In das Innengewinde 25 greift das Aussengewinde der Befestigungsschraube ein. Die Befestigungsschraube besteht insbesondere aus Kupfer oder niedrig legiertem Kupfer, wie CuBe, CuCoBe, CuTeP. Die beiden Befestigungslösungen, die in der Fig. 2 zuunterst dargestellt sind, zeigen in Abwandlung zum oberen Teil den Einbau einer Hülse 6. Diese Hülse 6 wird zusätzlich zur Abfuhr der Wärmeenergie an den Kühlkörper verwendet und wird in der Fachliteratur auch als Einschraublamelle oder Einschraublamellenhülse bezeichnet. Die Hauptfunktion der Hülse 6 besteht darin, den thermischen und elektrischen Kontakt zwischen der Befestigungsschraube 7 und dem Kühlkörper 13 zu verbessern. Die Hülse 6 ist in den Kühlkörper 13 eingeschraubt oder aufgesteckt, sodass durch die Verbindung, die insbesondere als Verschraubung oder als Presspassung ausgeführt ist, ein guter Wärmeübergang gewährleistet ist.

Für die weitere Darstellung der Anbindung des Targetsegments 9 an den Kühlkörper wird wieder auf die Fig. 2a Bezug genommen. Die Anbindung des Targetsegments 9 an den Kühlkörper 13 und an den Stromkontakt, der nicht dargestellt ist, wird hier durch die Kontaktlamellen 10 zwischen Targetsegment 9 und targetsegmentseitiger Oberfläche des Fortsatzes 23, durch die rückseitige Targetsegmentoberfläche des Targetsgements 9, der T-Mutter 8, über die T-Mutter, das Innengewinde 25 des Zylinders 22 der T-Mutter, sowie einer im Innengewinde 25 angeordneten Kontaktlamelle 3, in die Befestigungsschraube 7 sowie von der Befestigungsschraube 7 direkt an den Kühlköper oder alternativ dazu über die Hülse 6 an den Kühlkörper 13 erzielt. Die Kontaktlamelle 3 ist entweder Teil der Befestigungsschraube 7, wie im oberen Teil der Fig. 2a dargestellt ist, oder aber Teil des Zylinders 22 der T-Mutter 8, wie im unteren Teil der Fig. 2a dargestellt ist. Die Hülse 6 ist in Fig. 2a mit direktem Kontakt zum Kühlmittel dargestellt, welches durch die Kühlmittelkanäle 17 strömt. Durch eine lsolationszone 16 erfolgt die Isolierung der Beschichtungsquelle gegen Entladungen an den Aussenseiten. Die Isolationszone 16 befindet sich an der Aussenwand 15, welche auch Ausnehmungen für die Schraubenköpfe 4 der Befestigungsschrauben 7 enthält.

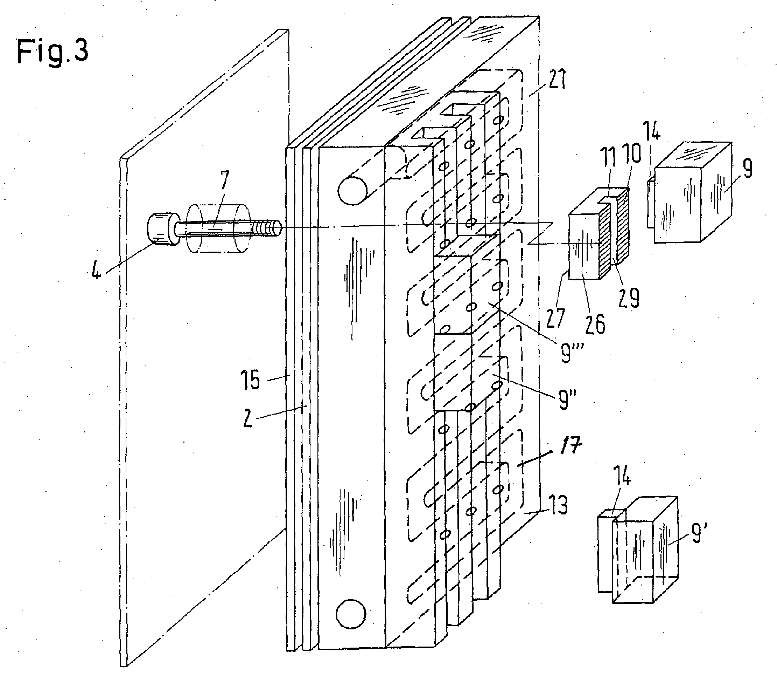

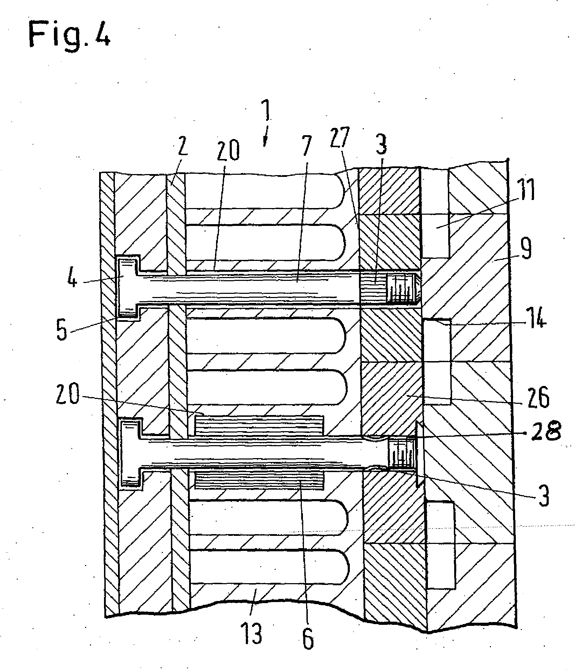

In einem weiteren Ausführungsbeispiel gemäss Fig. 3 und Fig. 4 wird die Anbindung des Targetsegments 9 an den Kühlkörper 13 und an den Stromkontakt, der nicht dargestellt ist, durch ein Verbindungsstück 26 bewirkt. Das Verbindungsstück 26 enthält auf seiner kühlkörperseitigen Oberfläche ein Innengewinde 28, welches zur Aufnahme einer Befestigungsschraube 7 dient, die gleich wie die Befestigungsschraube aus dem Ausführungsbeispiel gemäss Fig. 1 oder 2a ausgebildet ist. Das Verbindungsstück 26 enthält auf seiner kühlkörperseitigen Oberfläche eine Kontaktlamelle 27 und/oder eine galvanische Beschichtung zur Erhöhung des Strom- und/oder Wärmedurchgangs. Die Kontaktlamelle 27 braucht sich dabei nicht auf das Innengewinde 27 zu beschränken, sondern kann die gesamte Kontaktoberfläche erfassen. Der Vorteil besteht darin, dass Wärme direkt vom Verbindungsstück 26 an die Innenseite des Kühlkörpers 21 übertragen werden kann. Die Kühlmittelkanäle 17, die in Fig. 3 als nicht sichtbares Element dargestellt sind, befinden sich in der dargestellten Variante gerade in nächster Umgebung zur kühlerseitigen Oberfläche des Verbindungsstücks 26 und dessen Kontaktlamelle 27 und/oder galvanischen Beschichtung. Zwischen Targetsegment 9 und targetsegmentseitiger Oberfläche des Verbindungsstücks 26 werden Kontaktlamellen 11 in einer schlitzartigen Ausnehmung 29 vorgesehen. Die Ausnehmung 29 dient der Aufnahme eines Stegs 14 des Targetsegments 9, der zum Eingriff in die schlitzartige Ausnehmung 29 bestimmt ist.

Gemäss eines alternativen Ausführungsbeispiels, das ebenfalls in Fig. 3 dargestellt ist, erstreckt sich ein Verbindungsstück 26 über die gesamte Länge des Kühlkörpers. In diesem Fall ist es möglich, dass das Verbindungsstück 26 über mehrere Befestigungsschrauben 7 am Kühlkörper befestigt ist. Grundsätzlich sollte dann für das Verbindungsstück 26 und den Kühlkörper ein Werkstoff mit vergleichbarem Wärmeausdehnungskoeffizienten gewählt werden. An das Material werden beim Kühlkörper, sowie beim Verbindungsstück im wesentlichen dieselben Anforderungen gestellt, nämlich gute Wärmeleitfähigkeit, sowie gute elektrische Leitfähigkeit. Besonders geeignet haben sich Kupfer oder Kupferlegierungen für diesen Zweck erwiesen. Durch die Verwendung von Materialien mit gleichen oder ähnlichen Wärmeausdehnungskoeffizienten werden sich Verbindungsstück und Kühlkörper um denselben Betrag ausdehnen, sodass es weder in der Befestigungsschraube 7, noch in dem Verbindungsstück 26 zu unzulässigen Spannungen kommen kann. In einem Verbindungsstück 26 können dann mehrere Targetsegmente (9', 9", 9"'..) aufgenommen werden.

Gemäss eines weiteren Ausführungsbeispiels, welches in der Fig. 3 nicht gezeigt ist, könnte das Verbindungsstück 26 auch einstückig mit dem Kühlkörper ausgeführt sein. Die schlitzartigen Ausnehmungen 29 würden sich dann über die gesamte Innenseite 21 des Kühlkörpers erstrecken. Dabei könnten auch kreuzkanalartige Strukturen zum Einsatz kommen, sodass Targetsegmente 9 an Kreuzungspunkten befestigbar sind. Anstatt eines einfachen Stegs 14 wären dementsprechend auch sich kreuzende Stege möglich, was den Vorteil mit sich bringt, dass bei der Montage des Targetsegments 9 auch seine Position festliegt.

Der Wärmeübergang erfolgt wie im ersten Ausführungsbeispiel auch zwischen Targetsegment 9 und targetsegmentseitiger Oberfläche der schlitzartigen Ausnehmung 29 über den Steg 14 des Targetsegments, durch das Verbindungsstück 26 über das Innengewinde 28 und einer optional im Innengewinde 28 angeordneten Kontaktlamelle 3 in die Befestigungsschraube 7 sowie von der Befestigungsschraube 7 direkt an den Kühlköper oder alternativ dazu über die Hülse 6 an den Kühlkörper 13. Die Kontaktlamelle 3 ist entweder Teil der Befestigungsschraube 7, wie im oberen Teil der Fig. 4 dargestellt ist, oder aber des Innengewindes 28 des Verbindungsstücks 26, wie im unteren Teil der Fig. 4 dargestellt ist. Die Hülse 6 ist in Fig. 4 nicht mit direktem Kontakt zum Kühlmittel dargestellt, welches durch die Kühlmittelkanäle 17 strömt.

Innerhalb der schlitzartigen Ausnehmungen 29 können Kontaktlamellen 11 angeordnet werden, sodass wie in den unter Fig. 1 oder Fig. 2 beschriebenen Ausführungsformen eine Verbesserung des Strom- und Wärmeübergangs und eine Ausgleichsmöglichkeit für Längenänderungen, die durch die Erwärmung des Targetsegments 9 auftreten, erzielbar ist.

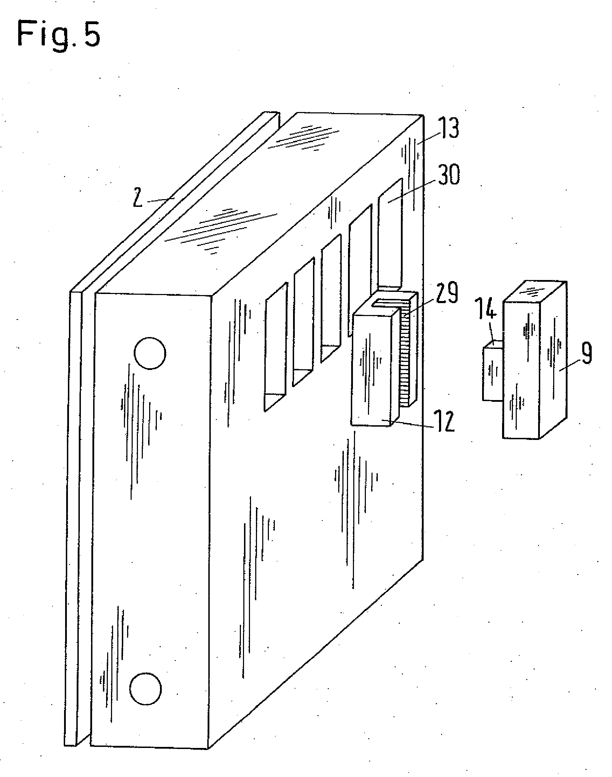

Die in Fig. 4 dargestellte Variante der Montage der Hülse 6 ist auch auf das Ausführungsbeispiel gemäss Fig. 2 verwendbar. Die Hülse 6 wird in den Kühlkörper eingeschraubt oder eingepresst. Hierzu sind Aufnahmemittel 20 im Kühlkörper vorgesehen, bei welchen es sich um Bohrungen für die Befestigungsschraube 7 und/oder die Hülse 6 handelt. Alternativ dazu kann die Hülse auch eine feste Verbindung mit der Befestigungsschraube 7 aufweisen, das heisst, eine Schraubverbindung oder vergleichbare formschlüssige Verbindung oder eine Pressverbindung. In die schlitzartige Ausnehmung 29 kann auch eine Gabelsteckvorrichtung 12 aufgenommen werden, wie sie in den nachfolgenden Ausführungsbeispielen gemäss Fig. 5 bis Fig. 8 beschrieben werden soll. Die Gabelsteckvorrichtung 12 umfasst insbesondere eine schlitzartige Ausnehmung, welche Kontaktlamellen an deren Innenseite enthält.

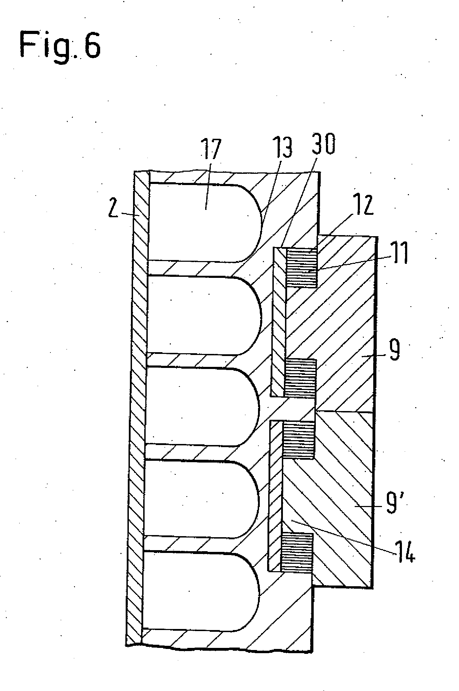

In einem weiteren Ausführungsbeispiel gemäss Fig. 5 ist die Targethaltevorrichtung 1 gleichzeitig als Kühlsystem ausgebildet. Die Targethaltevorrichtung 1 umfasst den Kühlkörper 13, in welchem sich Nuten 30 befinden, in welche zumindest je eine Gabelsteckvorrichtung 12 aufnehmbar ist. Der Kühlkörper 13 besteht aus einem gut wärmeleitenden und elektrisch leitfähigen Material, wie insbesondere Kupfer oder niedrig legiertem Kupfer. Die Gabelsteckvorrichtung 12 ist mit Kontaktlamellen 11 versehen, die ebenfalls aus gut wärmeleitfähigem und elektrisch leitfähigem Material bestehen, insbesondere aus niedrig legiertem Kupfer. Die Kontaktlamellen 11 können zur Herabsetzung des Kontaktwiderstands galvanisch beschichtet sein. Ein derartiger Kontaktwiderstand ist immer zwischen den aneinandergrenzenden Flächen zweier unmittelbar benachbarter, flächig aneinander liegender Körper vorhanden, insbesondere, wenn es sich um Körper aus verschiedenen Werkstoffen handelt, wie in diesem Fall Targetsegment und Targethaltevorrichtung. An einer derartigen Grenzfläche findet durch die Oberflächenrauhigkeiten und die dadurch bedingten Abstände zur gegenüberliegenden Oberfläche ein verringerter Wärmeübergang statt, der durch die galvanische Beschichtung, d.h. dem Auffüllen dieser Oberflächenrauhigkeiten verbessert werden kann. Im vorliegenden Ausführungsbeispiel entfallen wie in Fig. 6 gezeigt wird, die T-Muttern sowie die Befestigungsschrauben. Der Steg 14 des Targetsegments 9 erstreckt sich in Fig. 5 oder 6 nicht über die gesamte Höhe des Targetsegments. Es ist möglich, in den Zwischenräumen weitere Verbindungsmittel vorzusehen, die nicht im einzelnen dargestellt sind. So könnten konische Schieber, Exzenterwellen, Arretierungen mittels Steckkontakten, Zugfedern oder pneumatisch arbeitende Platten verwendet werden, um eine einen guten Halt des Targetsegments 9 in der Gabelsteckvorrichtung 12 zu gewährleisten. Alternativ dazu besteht auch die Möglichkeit, eines der vorgenannten Verbindungsmittel oder eine Kombination derselben anstatt der Gabelsteckvorrichtung 12 vorzusehen, sodass das Targetsegment im Kühlkörper 13 selbst befestigt wird.

In Fig. 6 ist ein Schnitt durch die Anordnung von 2 benachbarten Targetsegmenten (9,9') gezeigt. Jedes Targetsegment umfasst einen Steg 14, welcher von einer Gabelsteckvorrichtung 12 aufgenommen wird, an deren Seitenwänden und/oder im Bodenbereich Kontaktlamellen 11 angebracht sind. Weil der Steg 14 eine geringere Längsabmessung als die Nut 30 aufweist, in welcher die Gabelsteckvorrichtung 12 eingepasst ist, ist ein Teil der nur schematisch dargestellten Kontaktlamellen 11 sichtbar. Zur Verbesserung des Wärmeübergangs kann sich der Steg 14 auch über den grössten Teil der Längsabmessung der Nut erstrecken. Der Steg 14 sollte sich in Längsrichtung ungehindert ausdehnen können, sodass der Eintrag von Wärmespannungen in das Targetsegment vermieden wird.

Nicht dargestellt ist eine weitere Ausführungsvariante, nach welcher eine Serie übereinander oder eine Reihe nebeneinander liegender Nuten zu einem einzigen Kanal zusammengefasst ist, in welchen sich eine Folge von Gabelsteckvorrichtungen 12 befindet. Mittels Federelementen, deren Funktionsweise der Kontaktlamelle entspricht, können derartige Gabelsteckvorrichtungen in der Nut 30 verliersicher aufgenommen werden, sowie Wärmedehnungen über die Federspannung ausgeglichen werden.

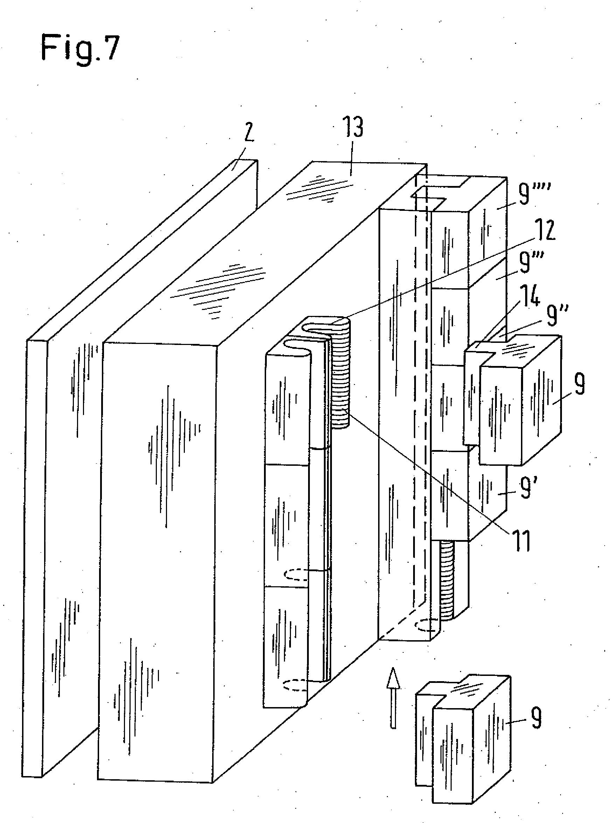

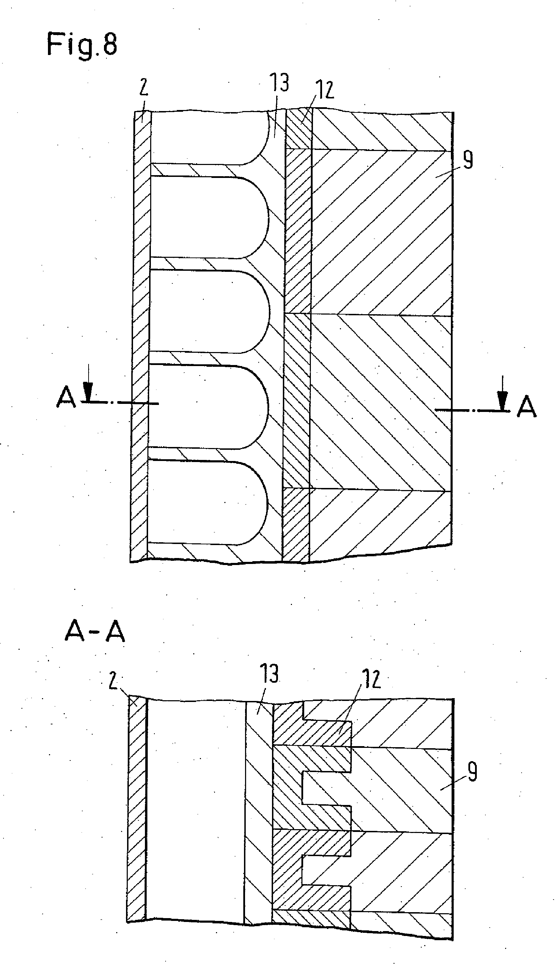

Nach einem weiteren Ausführungsbeispiel gemäss Fig. 7 und Fig. 8 können die Targetsegmente direkt auf den Kühlkörper 13 aufgesteckt werden. Bei bestimmten Materialien ergibt sich diese Notwendigkeit aus Gründen der Schwierigkeiten, sie mittels eines materialabtragenden Verfahrens mechanisch oder chemisch zu bearbeiten. Als Beispiel sind verpresste Pulver oder versinterte Pulver zu nennen, die in die Form eines quaderförmigen Targetsegments gepresst wurden und nachträglichen Formänderungen kaum zugänglich sind, weil es sich um eine lose Gefügestruktur nur teilweise miteinander in Verbindung stehender Partikel handelt. Zusätzlich können durch die Gestaltung der Steckverbindung die Bearbeitungskosten gesenkt werden, sowie der Materialaufwand verringert werden und vereinfacht sich die Montage. Die Anbindung der Targetsegmente an Kühlkörper und Stromanschluss erfolgt direkt über die ausgearbeiteten Stege 14 mittels der Gabelsteckvorrichtungen 12. Die Anbringung der Gabelsteckvorrichtungen 12 am Kühlkörper erfolgt im Unterschied zu dem vorherigen Ausführungsbeispiel nicht durch Einstecken in Nuten des Kühlkörpers sondern durch eine Haftverbindung, wie beispielsweise eine Klebeverbindung. Kontaktlamellen 11, sogenannte Gabelstecklamellen, werden in den Gabelsteckvorrichtungen 12 eingebracht. Alternativ dazu ist es möglich, die Gabelsteckvorrichtungen auf den Kühlkörper entweder aufzulöten, anzuschrauben, oder aus diesem mittels eines spanabhebenden Verfahrens, wie beispielsweise Fräsen, aus dem Kühlkörper herauszuarbeiten.

In diese Gabelsteckvorrichtungen werden die Targetsegmente direkt eingesteckt und fixiert. Die Targetsegmente werden durch geeignete Bearbeitungsmethoden (je nach Material: z.B.: EDM, Fräsen) so ausgearbeitet, dass ihr Steg genau und kontaktfest in die Gabelsteckvorrichtung 12 des Kühlkörpers 13 passt. Als Bearbeitungsmethoden für das Targetsegment kommen insbesondere Fräsen oder EDM (electron discharge machining) zum Einsatz. Electron Discharge Machining ist ein Hochpräzisionsbearbeitungsprozess, mittels welchem Material geschnitten oder gebohrt wird. Mittels elektrophysikalischem Verdampfen durch Anlegen einer elektrischen Spannung an eine Elektrode wird eine Bearbeitung selbst äusserst harter, zäher oder brüchiger Materialsorten ermöglicht.

Beste Beschichtungsergebnisse lassen sich mit folgenden Abmessungen für das Target erzielen, bei welchen die Breite des Targets 10 bis 1000 mm, insbesondere 25 bis 500 mm, bevorzugt 80 bis 140 mm beträgt.

Die Breite der Targetsegmente liegt vorzugsweise im Bereich von 0,05 bis 100 mm, insbesondere in einem Bereich von 0,05 bis 50 mm, besonders bevorzugt in einem Bereich von 0,05 bis 30 mm.

Optimale Beschichtungsergebnisse sind bei einem Abstand des zu beschichtenden Bauteils vom Target von 10 bis 1000 mm, insbesondere von 20 bis 500 mm, bevorzugt von 20 bis 150 mm erzielbar.

Die Targetsegmente 9 können nach jedem der vorhergehenden Ausführungsbeispiele in die Targethaltevorrichung 1 eingesteckt werden, und auf diese Weise auch wieder entnommen werden. Einzelne Targetsegmente können daher in allen Versionen auch völlig unabhängig von den anderen Targetsegmenten ersetzt werden. Durch den flächigen Kontakt von den Targetsegmenten zu den Gabelsteckvorrichtungen ergibt sich eine grosse effektive Wärmeübergangsfläche, sodass die Targethaltevorrichtung direkt an das Kühlsystem angebunden wird. Die im Targetsegment entstehende Wärme kann dann einfach abgeführt werden, sodass eine hohe Kühlrate erzielbar ist.

Als Material für die Targetsegmente kommen sowohl sehr weiche Materialien in Betracht, insbesondere reines Aluminium oder Magnaesium. Für diese Materialien waren bislang die schlechte Lötbarkeit ein limitieriender Faktor für die Erhöhung der Leistungseinkoppelung zur Beschleunigung des Beschichtungsverfahrens. Durch die Einkopplung höherer Ströme kann insbesondere für den Anwendungsfall in einem HS-PVD -Verfahren die zeitliche Dauer des Schichtauftrags durch eine erhöhte Zerstäubungsrate verkürzt werden.

Die Universalität der Verwendung von Targetsegmenten in Kombination mit einer der vorstehend beschriebenen Beschichtungsvorrichtungen zeigt sich dadurch, dass sehr harte oder spröde Materialien , wie insbesondere McrAlY zumindest mit derselben Leistungseinkoppelung beaufschlagbar sind, wie duktile Beschichtungsmaterialien.

Ein Target, welches mehrere Targetsegmente umfasst, wird in einem Verfahren zur Beschichtung eines Bauteils verwendet. Für dieses Verfahren werden eine Sputterquelle benötigt, welche das Target umfasst, sowie ein Gas zum Transport von abgestäubtem Beschichtungsmaterial zu dem Bauteil umfassend die Schritte: Kontakt eines Gases mit der Targetoberfläche, Herauslösen von Teilchen aus der Targetoberfläche, Mitnahme der herausgelösten Teilchen mit dem Gasstrom, Beschichtung des Bauteils mit Teilchen aus dem Gasstrom, wobei der Gasstrom die Teilchen des zu beschichtenden Bauteils aus jedem Targetsegment anteilig herauslöst. Die Teilchen umfassen geladene Teilchen, wie insbesondere lonen und/oder neutrale Teilchen, wie insbesondere Atome. Für die Durchführung des Sputterverfahrens werden die Sputterquelle, umfassend ein Target, welches die vorgehend beschriebenen Targetsegmente enthält, stosserzeugende Mittel, also insbesondere Gasatome und/oder lonen sowie Bewegungsmittel, insbesondere ein bewegter Gasstrom benötigt. Die stosserzeugenden Mittel kontaktieren das Target, um durch ihr stossartiges Auftreffen auf der Targetoberfläche Teilchen aus der Oberfläche des Targets durch die Stossenergie des auftreffenden stosserzeugenden Mittels herauzulösen. Ein Bewegungsmittel dient zum Transport der abgestäubten Teilchen von der Sputterquelle zu einem zu beschichtenden Bauteil.

Insbesondere werden gemäss des vorhin beschriebenen Verfahrens durch den Gasstrom Teilchen derart aus den Targetsegmenten herausgelöst, dass der Anteil der verschiedenen Schichtmaterialien oder Schichtmaterialkombinationen auf dem Bauteil dem Anteil der Targetsegmente mit entsprechenden Schichtmaterialien oder Schichtmaterialkombinationen auf dem Target entspricht, sodass das Bauteil mit einem ersten Schichtmaterial oder einer ersten Schichtmaterialkombination eines ersten Targetsegments und mit einem zweiten Schichtmaterial oder einer zweiten Schichtmaterialkombination eines zweiten Targetsegments anteilig beschichtet wird.

Insbesondere wird der Anteil der vom Gasstrom abgestäubten verschiedenen Schichtmaterialien oder Schichtmaterialkombinationen nach einem vorteilhaften Ausführungsbeispiel durch eine relativ zum Target bewegliche Gasverteilungseinheit verändert. Das anteilige Herauslösen von Bschichtungsmaterial aus jedem Targetsegment basiert auf folgender Gesetzmässigkeit, die sich experimentell in der Zusammensetzung der Schichten bei Variation der Anteil an voneinander verschienden Beschichtungsmaterialien gezeigt hat und zudem rechnerisch nachgewiesen werden konnte. Der Zusammenhang zwischen der Anordnung der Targetsegmente aus unterschiedlichem Schichtmaterial mit der auf dem beschichteten Bauteil erhältlichen Schichtzusammensetzung ergibt sich aus einer statistischen Analyse, die berücksichtigt, dass auf einem Target abestäubte Teilchen nach einer bestimmten durchlaufenen Weglänge so lange wieder auf einem Targetsegment, welches sich in geringerer Entfernung zum zu beschichtenden Bauteil befindet als das jeweils vorhergehende Targetsegment, abgeschieden werden, bis das bauteilseitige Ende des Targets erreicht ist und die Teilchen auf die Oberfläche des zu beschichtenden Bauteils abgeschieden werden.

Bei einer bestimmten Leistungseinkoppelung ist die mittlere Weglänge eines an einer bestimmten Stelle, d.h. auf einem ersten Targetsgement mit der vorgegebenen Zusammensetzung befindlichen Teilchens, von dessen Abstäubung bis zu dessen erneuter Abscheidung auf einem anderen Ort des erstenTargetsegments oder einem zweiten Targetsegement, welches zwischen erstem Targetsegment und dem zu beschichtenden Bauteil angeordnet ist, bekannt. Aus dem gesamten zurückzulegenden Weg des Teilchens vom Targetsegment bis zu dem zu beschichtenden Bauteil und der Dauer eines einmaligen Abstäubungs- und Abscheidungszyklus kann die Dauer bis zur Abscheidung jedes Teilchens bei Annahme eines Gasstroms konstanter Geschwindigkeit ermittelt werden.

Das heisst, dass ein Teilchen, welches sich ursprünglich auf einem Targetsegment befindet, das weiter weg von dem zu beschichtenden Bauteil gelegen ist, eine längere Zeitspanne benötigt, um auf dem Bauteil abgeschieden zu werden, als ein Teilchen, das in einer geringeren Distanz zum zu beschichtenden Bauteil angeordnet ist. Pro Zeiteinheit werden somit mehr Teilchen der Zusammensetzung auf dem zu beschichtenden Bauteil abgeschieden, die auf Targetsegmenten angeordnet sind, die näher an dem zu beschichtenden Bauteil gelegen sind, weil sie weniger Abstäubungs- und Abscheidungszyklen zu durchlaufen haben. Durch die Anordnung von Targetsegmenten mit Teilchen bestimmter Zusammensetzung an definierten Stellen des Targets kann unter Ausnützung der Kenntnis dieser Tatsache die Zusammensetzung der Beschichtung auf dem Bauteil genau eingestellt werden.

Ein Teilchen soll in dem vorhergehenden Absatz ein geladenes Teilchen, also ein lon und/oder ein neutrales Teilchen, insbesondere ein Atom und/oder ein aus mehreren der vorstehend genannten Gruppen gebildetes Molekül oder eines Partikels kristalliner oder amorpher Struktur umfassen.

Durch die Verwendung von Targetsegmenten ergibt sich die Möglichkeit, auf einem Target verschiedene Materialien anzordnen und unter Berücksichtigung der Abstäubungs- und Abscheidungszyklen vorherzusagen, in welcher Menge und in welcher Geschwindigkeit jedes der Materialien auf dem Bauteil abgeschieden wird.

Nach dem Abschluss jeder Beschichtung kann durch die Veränderung der Position der Targetsegmente ein Bauteil anderer Beschichtungszusammensetzung erzeugt werden, sodass durch den Einsatz von Targetsegmenten indivduelle Beschichtungslösungen realisierbar sind.

Alternativ dazu oder in Kombination mit den vorhergehenden Lösungen ist es möglich, die Geschwindigkeit und/oder die Gasmenge zu variieren. Insbesondere kann ein variabel positionierbarer Gasverteiler vorgesehen werden. Der Gasverteiler erfasst je nach seiner Position alle Targetsegmente oder nur einen Teil, sodass der Zeitpunkt frei einstellbar ist, zu welchem verschiedene Bereiche des Targets abgestäubt werden. Eine derartige Variante ist insbesondere zur Herstellung von mehrschichtigen Beschichtungen einsetzbar. Zudem können sehr schmale Schichten erzeugt werden, da die Position des Gasverteilers beliebig schnell veränderbar ist.

Mittels eines variablen Gasverteilers und/oder der Anordnung von Targetsegmenten zur Einstellung eines bestimmten Schichtaufbaus können monomolekulare oder monoatomare Schichten erzeugt werden. Derartige Schichten weisen eine Schichtdicke im Nanometerbereich auf und eignen sich zur Herstellung eines Schichtübergangs von metallischen zu keramischen Schichten, wozu heute TGO- Schichten (thermally grown oxides) mit einer Schichtdicke von wenigen Mikrometern zum Einsatz kommen.

### Bezugszeichenliste

- 1.: Targethaltevorrichtung
- 2.: Kühlkörperaussenwand
- 3.: Kontaktlamelle
- 4.: Schraubenkopf der Befestigungsschraube
- 5.: Tellerfeder
- 6.: Hülse
- 7.: Befestigungsschraube
- 8.: T-Mutter
- 9.: Targetsegment
- 10.: Kontaktlamelle für T-Mutter
- 11.: Kontaktlamelle für Targetsegment
- 12.: Gabelsteckvorrichtung
- 13.: Kühlkörper
- 14.: Steg
- 15.: Aussenwand
- 16.: Abschirmungsvorrichtung
- 17.: Kühlmittelkanal
- 18.: Einlass Kühlmittel
- 19.: Auslass Kühlmittel
- 20.: Aufnahmemittel
- 21.: Innenseite des Kühlkörpers
- 22.: Zylinder der T-Mutter
- 23.: Fortsatz
- 24.: Nut im Targetsegment
- 25.: Innengewinde T-Mutter
- 26.: Verbindungsstück
- 27.: Kontaktlamelle
- 28.: Innengewinde Verbindungsstück
- 29.: schlitzartige Ausnehmung
- 30.: Nut
- 31.: abgerundete Oberfläche
- 32.: Ausnehmung
- 33.: Nut in der T-Mutter
- 34.: Arretierelement
- 35.: erster Bereich der Kontaktlamelle
- 36.: zweiter Bereich der Kontaktlamelle
- 37.: Steg

## Patentansprüche

1. Target für eine Sputterquelle, wobei das Target in eine Vielzahl von austauschbaren Targetsegmenten (9) unterteilbar ist und jedes Targetsegment (9) Beschichtungsmaterial enthält, wobei jedes Targetsegment (9) an zumindest zwei benachbarte Targetsegmente (9', 9") grenzt, wobei jedes Targetsegment mittels maximal einem Befestigungsmittel (7,8,10) mit einem Grundkörper (2,13,15) verbindbar ist, **dadurch gekennzeichnet dass** Befestigungsmittel (7,8,10) und Targetsegment (9) einen Zwischenraum aufweisen, in welchem ein elektrisch und thermisch leitfähiges Mittel (6,10,11,12,27) angeordnet ist, sodass eine gleichmässige Stromstärke über die Oberfläche des Targetsegments (9) verteilbar sowie die am Targetsegment entstehende Wärme gleichmässig in den Grundkörper (2,13,15) abführbar ist.

2. Target für eine Sputterquelle nach Anspruch 1, wobei das elektrisch und thermisch leitfähige Mittel eine Kontaktlamelle (10,11,27) umfasst.

3. Target für eine Sputterquelle nach einem der vorhergehenden Ansprüche, wobei das Befestigungsmittel (7,8,10) eine Steckverbindung (8,12) umfasst.

4. Target nach Anspruch 3, wobei eine Steckverbindung (8,12) für eine Vielzahl von Targetsegmenten (9,9',9",9"',9"") vorgesehen ist.

5. Target für eine Sputterquelle nach einem der vorhergehenden Ansprüche, wobei der Grundkörper (2,13,15) einen Kühlkörper (13) umfasst, an welchen jedes Targetsegment (9) elektrisch und thermisch ankoppelbar ist.

6. Target für eine Sputterquelle nach nach einem der vorhergehenden Ansprüche, wobei jedes Targetsegment (9) vollständig aus Beschichtungsmaterial besteht.

7. Target für eine Sputterquelle nach einem der vorhergehenden Ansprüche, wobei zumindest ein Targetsegment (9) ein erstes Schichtmaterial oder eine erste Kombination von Schichtmaterialien umfasst, die sich von dem Schichtmaterial oder der Kombination von Schichtmaterialien eines zweiten Targetsegments (9',9",9"',9"") unterscheiden.

8. Beschichtungsquelle für ein Gasflusssputterverfahren nach einem der vorhergehenden Ansprüche.

9. Verfahren zur Beschichtung eines Bauteils umfassend eine Sputterquelle, ein Target nach einem der vorhergehenden Ansprüche sowie ein Gas zum Transport von abgestäubtem Beschichtungsmaterial zu dem Bauteil umfassend die Schritte: Kontakt eines Gases mit der Targetoberfläche, Herauslösen von Teilchen aus der Targetoberfläche, Mitnahme der herausgelösten Teilchen mit dem Gasstrom, Beschichtung des Bauteils mit Teilchen aus dem Gasstrom, **dadurch gekennzeichnet, dass** der Gasstrom die Teilchen des zu beschichtenden Bauteils aus jedem Targetsegment anteilig herauslöst.

10. Verfahren nach Anspruch 9, wobei der Gasstrom Teilchen derart aus den Targetsegmenten herauslöst, sodass der Anteil der verschiedenen Schichtmaterialien oder Schichtmaterialkombinationen auf dem Bauteil dem Anteil der Targetsegmente (9,9',9",9"',9"") mit entsprechenden Schichtmaterialien oder Schichtmaterialkombinationen auf dem Target entspricht, sodass das Bauteil mit einem ersten Schichtmaterial oder einer ersten Schichtmaterialkombination eines ersten Targetsegments (9) und mit einem zweiten Schichtmaterial oder einer zweiten Schichtmaterialkombination eines zweiten Targetsegments (9',9",9"',9"")anteilig beschichtet wird.

11. Verfahren nach Ansprüchen 9 oder 10, wobei der Anteil der vom Gasstrom abgestäubten verschiedenen Schichtmaterialien oder Schichtmaterialkombinationen durch eine relativ zum Target bewegliche Gasverteilungseinheit verändert wird.

12. Verfahren nach einem der Ansprüche 9 oder 10 oder 11, wobei das Gas ein Inertgas, insbesondere Argon umfasst und/oder das Gas als quasineutrales Plasma ausgebildet ist.
